# EUROPÄISCHE PATENTSCHRIFT

(11) **EP 2 650 255 B1**
(45) Veröffentlichungstag und Bekanntmachung des Hinweises auf die Patenterteilung: **13.05.2015**
(21) Anmeldenummer: 13157770.2
(22) Anmeldetag: 05.03.2013
(51) Int. Cl.: B81C 1/00, B05B 1/34

(54) **Verfahren zur Herstellung einer Mikrodüse**
Method for producing a micro-nozzle
Procédé de fabrication d'une microbuse

(30) Priorität: 10.04.2012 EP 12163649
(43) Veröffentlichungstag der Anmeldung: 16.10.2013
(73) Patentinhaber: Boehringer Ingelheim microParts GmbH, 44227 Dortmund (DE)
(72) Erfinder: Kadel, Klaus, 55216 INGELHEIM AM RHEIN (DE)
(74) Vertreter: Simon, Elke Anna Maria

(56) Entgegenhaltungen:
- DE-C1- 19 742 439
- US-A- 5 731 229

## Beschreibung

Die Erfindung bezieht sich auf ein Verfahren zur Herstellung einer Mikrodüse aus einem Verbund eines Siliziumwafers mit einer darauf aufgebrachten Glasplatte, umfassend das Befüllen von zwischen dem Siliziumwafer und der Glasplatte ausgebildeten mikroporösen Strukturen und/oder Kanälen mit einer Füllmasse, insbesondere Oktadekanol, und das nachfolgende Sägen des befüllten Verbundes.

Zur Herstellung von Mikrodüsen zur Abgabe eines Fluids ist aus DE 197 42 439 C1 bekannt, diese aus einem Verbund eines Siliziumwafers und einer darauf aufgebrachten Glasplatte herzustellen. Hierbei werden in die nachfolgend von einer Glasplatte abgedeckte Waferoberfläche mikroporöse Strukturen oder Kanäle, die im Zusammenwirken mit der Glasplatte dann Düsenkanäle ausbilden, geätzt. Durch entsprechendes Schneiden des Verbundes aus Siliziumwafer und Glasplatte lassen sich daraus dann durch Sägen Mikrodüsen herausschneiden. Damit während des Sägevorganges in die Düsenkanäle kein unerwünschtes Material eintritt, das später die Funktionsfähigkeit einer Mikrodüse beeinträchtigen könnte, werden diese mikroporösen Strukturen oder Kanäle zwischen der geätzten Oberseite des Siliziumwafers und der Unterseite der darauf aufliegenden Glasplatte mit einer Füllmasse, beispielsweise Oktadekanol, vor dem Durchführen des Sägeprozesses befüllt. Wenn diese Strukturen oder Kanäle unvollständig mit der Füllmasse befüllt sind, insbesondere die Einlass- und Auslassbereiche der daraus hergestellten Düsen unvollständig befüllt sind, ermöglicht dies das Eindringen von Partikeln während des Sägeprozesses. Beim späteren Reinigungsprozess zur Entfernung der Füllmasse können diese Partikel ggf. nicht beseitigt werden, so dass sich die Anzahl der aus einem Verbund eines Siliziumwafers üblicher Größe herstellbare Anzahl an den Qualitätsansprüchen genügenden Mikrodüsen reduziert.

Es ist Aufgabe der Erfindung, ein Verfahren der eingangs genannten Art zu schaffen, mit dem die vollständige Befüllung der mikroporösen Strukturen und/oder Kanäle verbessert wird.

Erfindungsgemäß wird die Aufgabe dadurch gelöst, dass der Verbund vor dem Sägen mit der Waferseite randseitig auf eine Halterung aufgelegt und mittels einer an der Halterung anliegenden Heizvorrichtung zum Aufschmelzen der Füllmasse aufgeheizt und anschließend ein Kühlvorgang mittels auf die Glasplatte geleitetem Kühlgas durchgeführt wird.

Die Kühlung des Verbundes erfolgt demnach von der Glasseite, wobei randseitig von dem unter der Glasplatte angeordneten Siliziumwafer noch Wärme nachgeliefert werden kann. Hierdurch wird eine gerichtete Erstarrung der Füllmasse, bei der es sich vorzugsweise um Oktadekanol handelt, erreicht. Durch die Vorgehensweise wird den unterschiedlichen Wärmeleitungskoeffizienten der verschiedenen beteiligten Materialien Rechnung getragen. Beispielsweise beträgt die Wärmeleitung von Silizium 148 W/mK, die von Glas 1,2 W/mK und die Wärmekapazität von Silizium 0,7 J/gK und von Glas 0,9 J/gK. Selbstverständlich können die mikroporösen Strukturen oder Kanäle sowohl in den Siliziumwafer als auch die Glasplatte eingearbeitet werden und die Geometrie der Halterung ist wählbar, wobei sowohl kreisförmige als auch viereckige, beispielsweise rechteckige Querschnitte verwendbar sind.

Vorzugsweise wird das Kühlgas im Zentrum des Verbundes aufgebracht, so dass zunächst dieser Bereich gekühlt und von den Randbereichen Wärme nachströmen kann. In Ausgestaltung wird der Verbund gegen Ende des Kühlvorganges von der Halterung abgehoben. Das Kühlgas, vorzugsweise Stickstoff, wird durch eine fest montierte oder insbesondere beweglich aufgehängte Kühldüse geleitet, so dass aufgrund des eintretenden Bernoulli-Effektes ein Abheben des Verbundes von der Halterung erfolgt und quasi ein "berührungsloser Greifer" realisiert ist, mit dem am Ende des Prozesses auch eine weitere Handhabung des Verbundes sowie über eine Druckregelung eine Einstellung des Abstandes des Silizium-Glas Verbundes zu der Kühldüse erfolgen kann. Durch das Abheben des Verbundes wird ein, insbesondere durch Verunreinigungen begünstigtes, Festgehen bzw. Festkleben des Siliziumwafer-Glas-Verbundes an der Halterung verhindert.

Bevorzugt weist die Halterung mindestens eine randseitige Öffnung auf, an der während des Aufheizvorganges ein den Siliziumwafer ansaugendes Vakuum angelegt wird. Hierdurch wird die Anlage des Siliziumwafers an die üblicherweise aus Metall bestehende und damit gut wärmeleitende Halterung bewirkt, so dass die Randbereiche des auf der Halterung aufliegenden Siliziumwafers Wärme in den Siliziumwafer nachliefern, während die Restfläche des Siliziumwafers aufgrund einer in dieser Halterungsposition unter dem Siliziumwafer in der Halterung ausgebildeten Ausnehmung nicht in Kontakt mit der Halterung steht. Die Öffnung kann beispielsweise als eine Ringnut ausgebildet sein. Natürlich können auch mehrere Öffnungen vorgesehen sein.

Zweckmäßigerweise wird während des Kühlvorganges aus der randseitigen Öffnung der Halterung Kühlgas, vorzugsweise Stickstoff, ausgeblasen. Das zugeführte Gas bewirkt ein Kühlen der Haltevorrichtung oder Halterung einerseits und aufgrund der dabei aufgenommenen Wärmeenergie eine Wärmenachlieferung an die Randbereiche des Wafers.

In einem vereinfachten Fall kann eine Kühldüse einige Millimeter über der Glasscheibe montiert werden und die Halterung des Verbundes über mechchanische Finger erfolgen, die neben der Erhöhung der Wärmeleitung in dem Silizium-Wafer auch eine Zentrierung auf der Halterung realsieren können.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der Erfindung ist nur durch die Ansprüche definiert.

Die Erfindung wird im Folgenden anhand eines Ausführungsbeispieles unter Bezugnahme auf die zugehörigen Zeichnungen näher erläutert. Es zeigt:

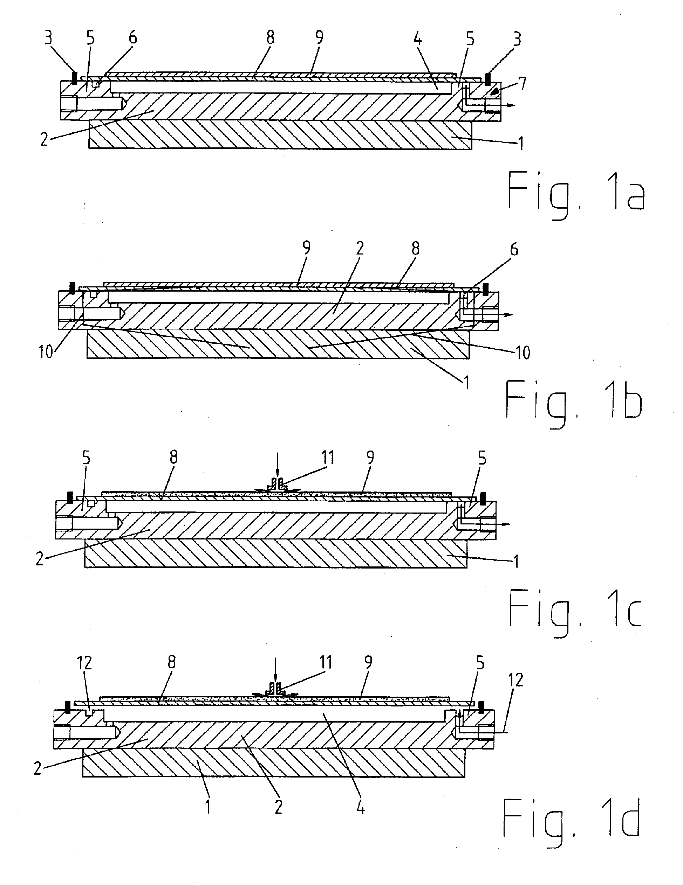

- Fig. 1a bis Fig. 1d: schematische Schnittdarstellungen einer Vorrichtung zur Durchführung verschiedener Schritte des erfindungsgemäßen Verfahrens.

Die Fig. 1a zeigt eine Heizvorrichtung 1 in Form einer Heizplatte mit einer darauf aufliegenden Halterung 2, die einen umlaufenden Begrenzungssteg 3, eine innere Ausnehmung 4 und zwischen dem Begrenzungssteg 3 bzw. einer sonstigen Anschlaghilfe, und der inneren Ausnehmung 4 einen die Ausnehmung 4 umgrenzenden äußeren Randbereich 5 aufweist. In dem äußeren Randbereich 5 ist eine kreisförmig umlaufende Öffnung 6 ausgebildet, die mit einer Anschlussleitung 7 in Verbindung stehen, über die ein Vakuum an die in Form einer Ringnut gestaltete Öffnung 6 anlegbar ist. Über eine weitere Bohrung ist die Ausnehmung 4 belüftet.

In einem ersten Schritt wird der Verbund aus einem Siliziumwafer 8 und einer darauf aufliegenden Glasplatte 9 auf den äußeren Randbereich 5 der Halterung 2 aufgelegt und mittels des an den Öffnungen 6 anliegenden Vakuums auf der Halterung 2 fixiert. Anschließend wird die Heizvorrichtung 1 eingeschaltet und ein Aufheizvorgang gestartet, wobei Wärme, wie durch Pfeile 10 angedeutet, von der Heizvorrichtung 1 über die Halterung 2 in den auf dem äußeren Randbereich 5 aufliegenden Siliziumwafer 8 eingetragen wird. Durch diesen Wärmeeintrag wird eine in den mikroporösen Strukturen bzw. Kanälen zwischen der geätzten Oberseite des Siliziumwafers 8 und der Unterseite der darauf aufliegenden Glasplatte 9 vorhandene Füllmasse, im Ausführungsbeispiel Oktadekanol, gemäß Fig. 1b aufgeschmolzen.

Anschließend wird, wie in Fig. 1c dargestellt, die Heizvorrichtung 1 abgeschaltet und mittig zentral von der Oberseite über eine fest montierte oder flexibel gelagerte Kühldüse 11 Kühlgas auf die Glasplatte 9 geleitet, was zu einer Abkühlung des Verbundes und einer Erstarrung der Füllmasse führt. Gleichzeitig wird durch das die Glasplatte 9 überströmende Kühlgas ein Bernoulli-Effekt erzielt, wodurch quasi ein "berührungsloser Greifer" zur Verfügung steht. Eine gerichtete Erstarrung der Füllmasse wird dadurch erreicht, dass zunächst im ersten Schritt gemäß Fig. 1a die Aufheizung des Verbundes von der Randseite, d. h. dem auf dem äußeren Randbereich 5 der Halterung 2 aufliegenden Bereich aus erfolgt. Ebenso wird während des Kühlvorganges von diesem äußeren Randbereich 5 in der Halterung 2 gespeicherte Wärme an den Randbereich des Siliziumwafers 8 nachgeliefert, während gleichzeitig die Glasplatte 9 auf ihrer Oberseite gekühlt wird. In einem weiteren, in Fig. 1d dargestellten und nicht zwingend notwendigen, aber für die Handhabung vorteilhaften Schritt wird durch die Anschlussleitung 7 Kühlgas 12, vorzugsweise mit leichtem Überdruck, durch die Öffnung 6 ausgeblasen, so dass der Verbund abhebt und das Kühlgas 12 in die Ausnehmung 4 einströmen und die Halterung 2 kühlen kann, wobei gleichzeitig durch die Aufnahme von Wärmeenergie dieses Kühlgas 12 insbesondere in den Randbereich des Siliziumwafers 8 Wärmeenergie nachliefert.

## Patentansprüche

1. Verfahren zur Herstellung einer Mikrodüse aus einem Verbund eines Siliziumwafers (8) mit einer darauf aufgebrachten Glasplatte (9), umfassend das Befüllen von zwischen dem Siliziumwafer (8) und der Glasplatte (9) ausgebildeten mikroporösen Strukturen und/oder Kanälen mit einer Füllmasse, insbesondere Oktadekanol, und das nachfolgende Sägen des befüllten Verbundes, **dadurch gekennzeichnet, dass** der Verbund vor dem Sägen mit der Waferseite randseitig auf eine Halterung (2) aufgelegt und mittels einer an der Halterung (2) anliegenden Heizvorrichtung (1) zum Aufschmelzen der Füllmasse aufgeheizt wird, und anschließend ein Kühlvorgang mittels auf die Glasplatte (9) geleitetem Kühlgas durchgeführt wird.

2. Verfahren nach Anspruch 1, **dadurch gekennzeichnet, dass** das Kühlgas im Zentrum des Verbundes aufgebracht wird.

3. Verfahren nach Anspruch 1 oder 2, **dadurch gekennzeichnet, dass** der Verbund während des Kühlvorganges von der Halterung (2) abgehoben wird.

4. Verfahren nach einem der Ansprüche 1 bis 3, **dadurch gekennzeichnet, dass** die Halterung (2) mindestens eine randseitige Öffnung (6) aufweist, an der während des Aufheizvorganges ein den Siliziumwafer (8) ansaugendes Vakuum angelegt wird.

5. Verfahren nach einem der Ansprüche 1 bis 4, **dadurch gekennzeichnet, dass** während des Kühlvorganges aus der randseitigen Öffnung (6) der Halterung (2) Kühlgas (12), vorzugsweise Stickstoff, derart ausgeblasen wird, dass der Verbund von der Halterung (2) abgehoben wird.

6. Verfahren nach Anspruch 1, **dadurch gekennzeichnet, dass** die Glasplatte (9) mittels mechanischer Finger der Halterung beabstandet und zentriert zu einer Kühldüse gehalten wird.

## Claims

1. Method for producing a micro-nozzle from a composite of a silicon wafer (8) with a glass plate (9) applied thereto, comprising filling microporous structures and/or channels arranged between the silicon wafer (8) and the glass plate (9) with a filling composition, particularly octadecanol, and subsequently sawing the filled composite, **characterised in that** before the sawing the composite is placed with the wafer side on its edge on a holder (2) and is heated by means of a heating device (1) abutting on the holder (2) in order to melt the filling composition, and then a cooling process is carried out by means of a cooling gas directed onto the glass plate (9).

2. Method according to claim 1, **characterised in that** the cooling gas is applied in the centre of the composite.

3. Method according to claim 1 or 2, **characterised in that** the composite is lifted away from the holder (2) during the cooling process.

4. Method according to one of claims 1 to 3, **characterised in that** the holder (2) comprises at least one opening (6) on its edge, at which a vacuum that aspirates the silicon wafer (8) is applied during the heating process.

5. Method according to one of claims 1 to 4, **characterised in that**, during the cooling process, cooling gas (12), preferably nitrogen, is blown out of the opening (6) on the edge of the holder (2) such that the composite is lifted away from the holder (2).

6. Method according to claim 1, **characterised in that** the glass plate (9) is held at a spacing from the holder and centred with respect to a cooling nozzle by means of mechanical fingers.

## Revendications

1. Procédé servant à fabriquer une microbuse à partir d'un composite d'une tranche de silicium (8) comprenant une plaque de verre (9) appliquée sur celle-ci, comprenant le remplissage de structures microporeuses et/ou de canaux microporeux réalisés entre la tranche de silicium (8) et la plaque de verre (9) d'une masse de remplissage, en particulier d'un octadécanol, puis ensuite le sciage du composite rempli, **caractérisé en ce que** le composite est posé avant le sciage sur sa bordure côté tranche sur un support (2) et est chauffé au moyen d'un dispositif de chauffage (1) reposant au niveau du support (2) pour faire fondre la masse de remplissage, et **en ce qu'**immédiatement après une opération de refroidissement est effectuée au moyen d'un gaz de refroidissement acheminé sur la plaque de verre (9).

2. Procédé selon la revendication 1, **caractérisé en ce que** le gaz de refroidissement est appliqué au centre du composite.

3. Procédé selon la revendication 1 ou 2, **caractérisé en ce que** le composite est retiré du support (2) au cours de l'opération de refroidissement.

4. Procédé selon l'une quelconque des revendications 1 à 3, **caractérisé en ce que** le support (2) présente au moins une ouverture (6) à sa bordure, au niveau de laquelle un vide aspirant la tranche de silicium (8) est appliqué au cours de l'opération de chauffage.

5. Procédé selon l'une quelconque des revendications 1 à 4, **caractérisé en ce que**, au cours de l'opération de refroidissement, du gaz de refroidissement (12), de préférence de l'azote, est soufflé de manière à sortir de l'ouverture (6) à la bordure du support (2) de telle manière que le composite est retiré du support (2).

6. Procédé selon la revendication 1, **caractérisé en ce que** la plaque de verre (9) est maintenue au moyen de doigts mécaniques du support à distance et de manière centrée par rapport à une buse de refroidissement.
